(19) Europäisches Patentamt
European Patent Office
Office européen des brevets

(11) EP 4 279 524 A1

# (12) EUROPEAN PATENT APPLICATION

(43) Date of publication:
**22.11.2023 Bulletin 2023/47**

(21) Application number: **22174528.4**

(22) Date of filing: **20.05.2022**

(51) International Patent Classification (IPC):
***C08G 61/12*** *(2006.01)* ***C09D 165/00*** *(2006.01)*
***C08L 65/00*** *(2006.01)* ***H01L 51/00*** *(2006.01)*

(52) Cooperative Patent Classification (CPC):
**C09D 165/00; C08G 61/126; C08L 65/00; H10K 85/113;** C08G 2261/1424; C08G 2261/18; C08G 2261/312; C08G 2261/3223; C08G 2261/43; C08G 2261/51; C08G 2261/59; C08G 2261/63; C08G 2261/64; C08G 2261/794; C08G 2261/91;

(Cont.)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **AGFA-GEVAERT NV**
**2640 Mortsel (BE)**

(72) Inventors:
- **HERCKENS, Roald**
**2640 Mortsel (BE)**
- **LOCCUFIER, Johan**
**2640 Mortsel (BE)**

(74) Representative: **Viaene, Kris**
**AGFA NV**
**Intellectual Property Department**
**Septestraat 27**
**2640 Mortsel (BE)**

## (54) NOVEL POLYTHIOPHENE/POLYANION COMPOSITIONS

(57) A conductive polymer dispersion including:
(a) at least one oligo- or polythiophene obtained by copolymerization of at least one monomer according to Formula I and at least one monomer according to Formula II,

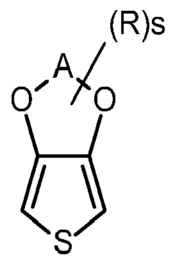

Formula I

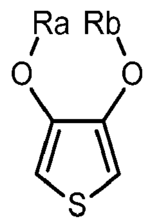

Formula II

wherein
A represents a substituted or unsubstituted $C_1$ to $C_5$ alkylene bridge;
R is selected from the group consisting of a linear or branched substituted or unsubstituted $C_1$-$C_{18}$-alkyl group, a substituted or unsubstituted $C_5$-$C_{12}$-cycloalkyl group, a substituted or unsubstituted $C_6$-$C_{14}$-aryl group, a substituted or unsubstituted $C_7$-$C_{18}$-aralkyl group and a hydroxyl group;
s represents an integer from 0 to 8;
Ra and Rb are independently from each other selected from the group consisting of hydrogen, a substituted or unsubstituted alkyl group, a substituted or unsubstituted alkenyl group, a substituted or unsubstituted alkynyl group, a substituted or unsubstituted aralkyl group, a substituted or unsubstituted alkaryl group and a substituted or unsubstituted aryl or heteroaryl group;

(b) a polymeric polyanion wherein at least 75 mol% of the monomeric units of the polymeric polyanion are functionalized with a functional group selected from the group consisting of a sulfonic acid or salt thereof, a phosphonic acid or salt

EP 4 279 524 A1

thereof, a phosphate ester or salt thereof, a sulfate ester or salt thereof and a carboxylic acid or salt thereof, characterized in that a weight ratio of the monomer according to Formula I to the monomer according to Formula II is from 75/25 to 25/75.

(52) Cooperative Patent Classification (CPC): (Cont.)
C08G 2261/95; H10K 71/12

## Description

### Technical field of the Invention

The present invention relates to novel polythiophene/polyanion compositions and their use in various applications, such as for example antistatic layers.

### Background art for the invention

Antistatic coatings are applied on surfaces that poorly conduct electricity, such as plastic films or paper, to reduce or prevent the static electricity buildup. These coatings are a vital component in several electronic applications as such static electricity may damage the devices used. For example on antistatic packaging trays and in display applications such as liquid-crystal display (LCD) or organic light-emitting diode (OLED) antistatic coatings are used to prevent electro-static discharge.

Conductive polymers are used to prepare antistatic coatings due to the possibility to tune their conductivity and their processability for different coating techniques and substrates. Among these, poly(3,4-ethylenedioxythiophene):poly(styrene sulfonate) (PEDOT:PSS) is frequently used, a conductive polymer complex which can be prepared as an aqueous dispersion and which can be easily processed by conventional coating techniques.

Formulations of PEDOT:PSS are developed in order to, for example, optimize coating properties, strengthen the adhesion to substrates or improve the stability of the coating layer. Organic solvents such as methanol, ethanol or isopropanol are often added. These solvents can for example improve the dispersability of other components in the formulation. However, it is observed that the addition of organic solvents to an aqueous dispersion of PEDOT:PSS may lower the gelation stability of the dispersion. An increased viscosity or gel formation may severely decrease the coatability of the formulations.

Conductive polymer dispersions with a high gelation stability upon the addition of organic solvents are therefore of importance to allow the development of novel antistatic coating formulations.

WO2021/172199 (Panasonic) discloses a thiophene copolymer of 3,4-ethylenedioxythiophene (EDOT) and a 3,4-dialkylthiophene. The amount of 3,4-dialkylthiophene in the copolymer is from 0.005 to 13 wt% relative to the total weight of the thiophene copolymer. The thiophene copolymers are used in capacitors.

The copolymerization of EDOT and 3,4-dimethoxythiophene (90/10 ratio) in the presence of PSS is described in US9613757 (Eternal Materials Co Ltd). The particle size of the aqueous polymer dispersion and the surface resistivity of the coated film are disclosed. In a different patent by Eternal Materials Co Ltd, copolymers with varying weight ratios are prepared in an iron(III)p-toluenesulfonate ethanol solution (US9036333). Polymer capacitors were prepared in both patents and in neither the gelation behavior of the conductive polymer dispersion in the presence of organic solvents is described.

JP2012255049 (Tosoh) discloses copolymers of EDOT and 3,4-dialkoxythiophene monomers in molar ratios of 99.99/0.01 to 80/20. The thermal stability of the coated films is determined by measuring the surface resistance before and after subjection to a heating test. The compositions are developed for an overcurrent protection element. The gelation stability upon addition of organic solvents is not mentioned.

### Summary of the invention

It is an object of the invention to provide a conductive polymer dispersion having an improved gelation stability upon the addition of organic solvents.

The object of the invention is realized by a dispersion as defined in claim 1.

Further objects of the invention will become apparent from the description hereinafter.

### Detailed description of the invention

#### Definitions

The term "monofunctional" in e.g. monofunctional polymerizable compound means that the polymerizable compound includes one polymerizable group.

The term "difunctional" in e.g. difunctional polymerizable compound means that the polymerizable compound includes two polymerizable groups.

The term "polyfunctional" in e.g. polyfunctional polymerizable compound means that the polymerizable compound includes more than two polymerizable groups.

The term "alkyl" means all variants possible for each number of carbon atoms in the alkyl group i.e. methyl,

ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc.

Unless other wise specified a substituted or unsubstituted alkyl group is preferably a $C_1$ to $C_6$-alkyl group.

Unless otherwise specified a substituted or unsubstituted alkenyl group is preferably a $C_2$ to $C_6$-alkenyl group.

Unless otherwise specified a substituted or unsubstituted alkynyl group is preferably a $C_2$ to $C_6$-alkynyl group.

Unless otherwise specified a substituted or unsubstituted alkaryl group is preferably a phenyl or naphthyl group including one, two, three or more $C_1$ to $C_6$-alkyl groups.

Unless otherwise specified a substituted or unsubstituted aralkyl group is preferably a $C_7$ to $C_{20}$-alkyl group including a phenyl group or naphthyl group.

Unless otherwise specified a substituted or unsubstituted aryl group is preferably a phenyl group or naphthyl group.

Unless otherwise specified a substituted or unsubstituted heteroaryl group is preferably a five- or six-membered ring substituted by one, two or three oxygen atoms, nitrogen atoms, sulphur atoms, selenium atoms or combinations thereof.

Unless otherwise specified a substituted or unsubstituted alkylene group is preferably a $C_1$ to $C_6$-alkylene group.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.

Unless otherwise specified a substituted alkyl group, a substituted alkenyl group, a substituted alkynyl group, a substituted aralkyl group, a substituted alkaryl group, a substituted aryl and a substituted heteroaryl group are preferably substituted by one or more constituents selected from the group consisting of methyl, ethyl, n-propyl, isopropyl, n-butyl, isobutyl and tertiary-butyl, ester, amide, amine, ether, thioether, ketone, aldehyde, sulfoxide, sulfone, sulfonate ester, sulphonamide, -Cl, -Br, -I, -OH, -SH, -CN and $-NO_2$.

## Conductive polymer dispersion

A dispersion comprising a conductive polymer is referred to herein as a conductive polymer dispersion.

The conductive dispersion according to the present invention includes a conductive polymer and a polyanion, both as described below.

A dispersion medium of the conductive polymer dispersion is preferably selected from water, a water-soluble organic solvent, or mixtures thereof. Preferred organic solvents are protic organic solvents, such as alcohols or acids. The dispersion medium is preferably water.

The conductive polymer dispersion may comprise other ingredients such as dispersing agents.

The conductive polymer dispersion is preferably prepared as described below.

The median particle size ($d_{50}$) of the polythiophene/polyanion particles is preferably from 1 to 150 nm, more preferably from 2 to 50 nm, most preferably from 5 to 40 nm. The $d_{50}$ particle size is preferably measured by laser diffraction.

## Conductive polymer

The conductive polymer according to the present invention is an oligo- or polythiophene obtained by copolymerization of at least one monomer according to Formula I and at least one monomer according to Formula II,

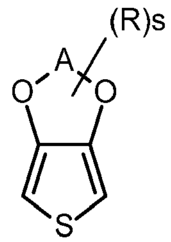

Formula I

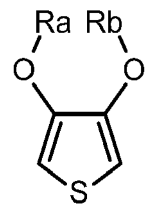

Formula II

wherein

A represents a substituted or unsubstituted $C_1$ to $C_5$ alkylene bridge;
R is selected from the group consisting of a linear or branched substituted or unsubstituted $C_1$-$C_{18}$-alkyl group, a

substituted or unsubstituted $C_5$-$C_{12}$-cycloalkyl group, a substituted or unsubstituted $C_6$-$C_{14}$-aryl group, a substituted or unsubstituted $C_7$-$C_{18}$-aralkyl group, a substituted or unsubstituted $C_1$-$C_4$-hydroxyalkyl group and a hydroxyl group;
s represents an integer from 0 to 8;
Ra and Rb are independently selected from the group consisting of hydrogen, a substituted or unsubstituted alkyl group, a substituted or unsubstituted alkenyl group, a substituted or unsubstituted alkynyl group, a substituted or unsubstituted aralkyl group, a substituted or unsubstituted alkaryl group and a substituted or unsubstituted aryl or heteroaryl group;

characterized in that the weight ratio of the monomer according to Formula I to the monomer according to Formula II is from 75/25 to 25/75, preferably from 70/30 to 40/60, more preferably from 65/35 to 50/50.

Monomer according to Formula I

The conductive polymer according to the present invention is an oligo- or polythiophene obtained by copolymerization of at least one monomer according to Formula I,

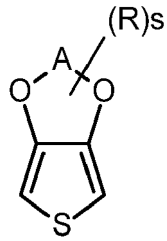

Formula I

wherein

A represents a substituted or unsubstituted $C_1$ to $C_5$ alkylene bridge;
R is selected from the group consisting of a linear or branched substituted or unsubstituted $C_1$-$C_{18}$-alkyl group, a substituted or unsubstituted $C_5$-$C_{12}$-cycloalkyl group, a substituted or unsubstituted $C_6$-$C_{14}$-aryl group, a substituted or unsubstituted $C_7$-$C_{18}$-aralkyl group, a substituted or unsubstituted $C_1$-$C_4$-hydroxyalkyl group and a hydroxyl group;
s represents an integer from 0 to 8.

The term $C_1$ to $C_5$ alkylene bridge as used in Formula I means an alkylene bridge comprising 1 to 5 carbon atoms.
The $C_1$ to $C_5$ alkylene bridge is preferably methylene, ethylene, n-propylene, n-butylene or n-pentylene.
A $C_1$-$C_{18}$-alkyl radical includes linear or branched $C_1$-$C_{18}$-alkyl radicals, such as methyl, ethyl, n- or isopropyl, n-, iso-, sec- or tert-butyl, n-pentyl, 1-methylbutyl, 2-methylbutyl, 3-methylbutyl, 1-ethylpropyl, 1,1- dimethylpropyl, 1,2-dimethylpropyl, 2,2-dimethylpropyl, n-hexyl, n-heptyl, n-octyl, 2-ethylhexyl, n-nonyl, n-decyl, n-undecyl, n-dodecyl, n-tridecyl, n-tetradecyl, n-hexadecyl or n-octadecyl.
A $C_5$-$C_{12}$-cycloalkyl radical represents, for example, cyclopentyl, cyclohexyl, cycloheptyl, cyclooctyl, cyclononyl or cyclodecyl.
A $C_6$-$C_{14}$-aryl radical represents, for example, phenyl or naphthyl.
A $C_7$-$C_{18}$-aralkyl radical represent, for example, benzyl, o-, m-, p-tolyl, 2,3-, 2,4-, 2,5-, 2,6-, 3,4-, 3,5-xylyl or mesityl.
Preferred substituents are alkyl, cycloalkyl, aryl, aralkyl, alkoxy, halogen, ether, thioether, disulphide, sulphoxide, sulphone, sulphonate, amino, aldehyde, keto, carboxylic acid ester, carboxylic acid, carbonate, carboxylate, cyano, alkylsilane and alkoxysilane groups and carboxamide groups.
A in Formula I is preferably an ethylene bridge.
In a particular preferred embodiment, the monomer according to Formula I is 3,4-ethylenedioxythiophene.

Monomer according to Formula II

The conductive polymer according to the present invention is an oligo- or polythiophene obtained by copolymerization of at least one monomer according to Formula II,

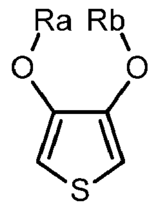

Formula II

wherein

Ra and Rb are independently selected from the group consisting of hydrogen, a substituted or unsubstituted alkyl group, a substituted or unsubstituted alkenyl group, a substituted or unsubstituted alkynyl group, a substituted or unsubstituted aralkyl group, a substituted or unsubstituted alkaryl group and a substituted or unsubstituted aryl or heteroaryl group.

Ra and Rb in Formula II preferably represent an alkyl group.

In a particular preferred embodiment, the monomer according to Formula II is 3,4-dimethoxythiophene.

Typical monomers according to Formula II are shown in Table 1 without being limited thereto.

Table 1

| Chemical Structure | Monomer II |
|---|---|
| 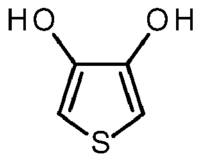 | Monomer II-1 |
| 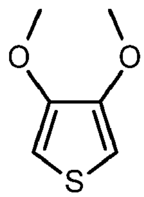 | Monomer II-2 |
| 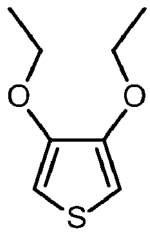 | Monomer II-3 |
| 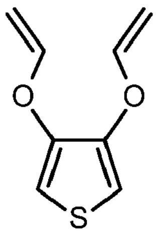 | Monomer II-4 |

(continued)

| Chemical Structure | Monomer II |
|---|---|
| 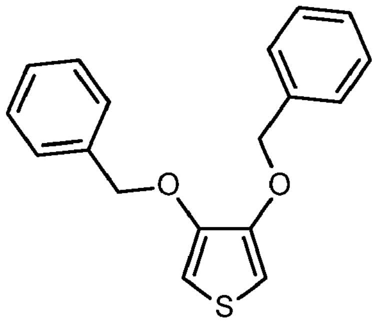 | Monomer II-5 |
| 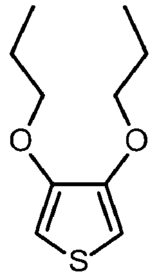 | Monomer II-6 |
| 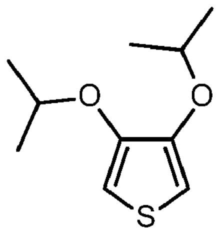 | Monomer II-7 |
| 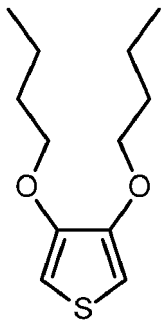 | Monomer II-8 |
| 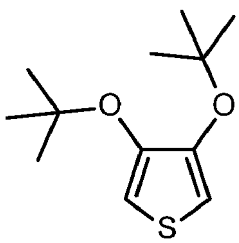 | Monomer II-9 |

(continued)

| Chemical Structure | Monomer II |
|---|---|
| 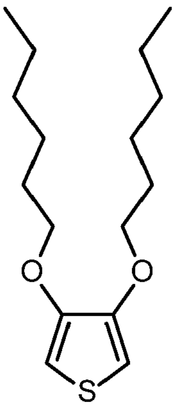 | Monomer II-10 |
| 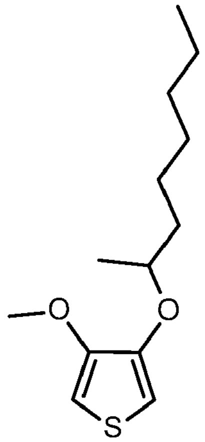 | Monomer II-11 |
| 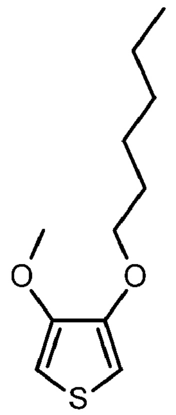 | Monomer II-12 |

Polyanion

The conductive polymer dispersion comprises a polymeric polyanion wherein at least 75 mol%, more preferably at least 80 mol%, more preferably at least 90 mol%, most preferably at least 99 mol %, of the monomeric units of the polyanion comprise a substituent selected from the group consisting of a sulfonic acid or salt thereof, a phosphonic acid or salt thereof, a phosphate ester or salt thereof, a sulfate ester or salt thereof and a carboxylic acid or salt thereof.

The functional group is preferably a sulfonic acid or salt thereof.

The polymeric polyanion may be a copolymer of different monomers but is preferably a homopolymer.

In a particularly preferred embodiment the polymeric polyanion is styrene based.

According to a particular preferred embodiment, the polyanion is poly(4-styrenesulfonic acid) or a salt thereof.

The weight average molecular weight (Mw) of the polymeric anion is not particularly limited but is preferably

from 1 000 to 1 000 000 Da, more preferably from 50 000 to 500 000 Da and most preferably from 100 000 to 300 000 Da.

Preparation of the conductive polymer

The polythiophene polymers are preferably prepared by oxidative polymerization of the thiophene monomers described above in an aqueous medium.

The oxidative polymerization is preferably carried out in the presence of a polyanion.

The concentration of the thiophene monomer in the aqueous phase medium is preferably in a range from 0.1 to 25 wt%, preferably in a range from 0.5 to 10 wt%, all relative to the total weight of the aqueous reaction medium.

Suitable oxidizing agents are iron(III) salts, such as $FeCl_3$, and iron(III) salts of aromatic and aliphatic sulfonic acids; $H_2O_2$; $K_2Cr_2O_7$; $KMnO_4$, alkali metal perborates; alkali metal or ammonium persulfates; and mixtures thereof.

Further suitable oxidants are described, for example, in Handbook of Conducting Polymers (Ed. Skotheim, T. A.), Marcel Dekker: New York, 1986, Vol. 1, pages 46-57.

Particularly preferred oxidizing agents are salts of a peroxydisulfate, in particular $K_2S_2O_8$, $Na_2S_2O_8$; iron(III) salts, in particular iron(III) chloride; or a combination thereof.

A mixture of salts of a peroxydisulfate and at least one further compound that catalyzes the cleavage of the peroxydisulfate, such as an Fe(III) salt, is particular preferred.

According to a particularly preferred embodiment the oxidizing agent is a mixture of $Fe_2(SO_4)_3$ and $Na_2S_2O_8$.

There are different ways for preparing the aqueous reaction medium. The thiophene monomer can be dissolved or dispersed in the aqueous reaction medium followed by the addition of the oxidizing agent(s), which can also be dissolved or dispersed in an aqueous phase, or the oxidizing agent(s) is/are first dissolved or dispersed in the aqueous reaction medium, followed by the addition of the thiophene monomer, which can also be dissolved or dispersed in a an aqueous phase.

If more than one oxidizing agent is used, for example a mixture of $Fe_2(SO_4)_3$ and $Na_2S_2O_8$, it is furthermore possible to first mix one of these components with the thiophene monomer in the aqueous reaction medium followed by the addition of the second oxidizing agent.

The oxidative polymerization is preferably carried out under an inert atmosphere as disclosed in EP-11453877 (Agfa Gevaert). The oxygen content of the reaction medium when the oxidizing agent, for example a salt of peroxydisulfate, is added to it is preferably less than 3 mg per liter, more preferably less than 1.5 mg/liter, most preferably less than 0.5 mg/liter.

The concentration of oxygen in the reaction medium can be regulated by any means, such as freeze-thaw techniques, prolonged bubbling of an inert gas such as Argon, Nitrogen or Helium through the reaction medium, consumption of oxygen in a sacrificial reaction under an inert gas blanket. An inert gas is preferably bubbled through the reaction medium until the polymerization is completed thereby maintaining the oxygen concentration below 3 mg/l.

The oxidative polymerization is preferably carried out at low pH, as disclosed in EP-A 1384739 (Heraeus). The pH is preferably 1.5 or less, more preferably 1.00 or less.

To adjust the pH, an acid may be used, preferably selected from the group of water-soluble inorganic acids and water-soluble organic acids. Examples of inorganic acids are hydrochloric acid, sulfuric acid, nitric acid and phosphoric acid. Examples of organic acids include p-toluenesulfonic acid, benzenesulfonic acid, methanesulfonic acid and trifluoromethanesulfonic acid.

The temperature of the reaction mixture is preferably between 0 to 100°C, more preferably between 0 to 50°C, most preferably between 5 and 30°C.

The amount of thiophene monomers and polyanions in the reaction mixture are chosen so that stable polythiophene/polyanion dispersions are obtained of which the solid content is preferably from 0.05 to 25 wt%, more preferably from 0.1 to 10 wt%, most preferably from 0.8 to 2 wt%.

After the polymerization reaction is completed the liquid composition may be further purified, for example by means of filtration, in particular by means of ultrafiltration, and/or by a treatment with ion exchanger, in particular by a treatment with an anion exchanger and a cation exchanger.

After the purification step, the conductive polymer dispersion may be further optimized for the application wherein it will be used. For example, when used for preparing an antistatic layer, a liquid formulation described below may be prepared from the conductive polymer dispersion.

Various homogenization techniques may be used during the preparation of the conductive polymer. The homogenizing techniques may be selected from:

- ultrasonic homogenization techniques;
- pressure homogenization techniques; and
- mechanical homogenization techniques.

Preferred mechanical homogenizers are rotor-stator homogenizers and blade type homogenizers. Another mechanical homogenization technique may be the use of a spinning disk reactor.

Preferred high-pressure homogenizers, such as for example a Gaulin homogenizer or an Ariete homogenizer, force the dispersion through a very narrow channel or orifice under pressure. Another preferred high-pressure homogenizer is a microfluidizer.

Two or more homogenizers may be used in combination, preferably in a consecutive way.

The homogenization techniques may be used before, during and after the polymerization reaction. These homogenization techniques may also be used during the preparation of the liquid formulation described below.

Liquid Formulation

Depending on the application wherein the conductive polymer dispersion is used additional ingredients may be added to the conductive polymer dispersion thereby forming a liquid formulation optimized for the application.

All or part of the additional ingredients described below may also be added to the conductive polymer dispersion referred to above.

In addition to the conductive polymer and the polyanion described above the formulation may comprise further additives such as solvents, surface-active substances, adhesion promoters, crosslinking agents, binders, conductivity increasing compounds, heat- and moisture-stability improving compounds, acidic compounds, and pH regulating compounds.

A preferred solvent is water or a water-miscible solvent or a mixture thereof. A water-miscible solvent is preferably selected from the group consisting of aliphatic alcohols; such as methanol, ethanol, n-propanol and isopropanol; diacetone alcohols; aliphatic ketones, such as acetone; and methyl ethyl ketone.

According to a preferred embodiment of the liquid formulation at least 95 wt%, more preferably at least 99 wt%, most preferably at least 99.5 wt% of the total amount of solvents in the liquid formulation is water or a mixture of water and an alcohol selected from the group consisting of methanol, ethanol, n-propanol, isopropanol, n-butanol or a combination thereof.

The liquid formulation preferably includes from 2 to 50 wt% of an organic solvent. The organic solvent is preferably methanol, ethanol, n-propanol, isopropanol, n-butanol or a combination thereof.

The surface-active compounds may be:

- anionic surfactants such as alkylbenzenesulphonic acids and salts, paraffin sulphonates, alcohol sulphonates, ether sulphonates, sulphosuccinates, phosphate esters, alkyl ether carboxylic acids or carboxylates;
- cationic surfactants such as quaternary alkylammonium salts;
- nonionic surfactants such as linear alcohol ethoxylates, oxo alcohol ethoxylates, alkylphenol ethoxylates or alkyl polyglucosides; and
- zwitterionic surfactants such as compounds comprising both a carboxylic acid group and a quaternary ammonium group, for example lauryl-N,N - (dimethyl-ammonio)-butyrate and lauryl-N,N-(dimethyl)-glycinebetaine, compounds comprising both a sulfuric acid group and quaternary ammonium group, for example 3-[(3-cholamido-propyl)dimethylammonio]-1-propanesulfonate, 3-(4-tert-butyl-1-pyridinio)-1-propanesulfonate, 3-(1-pyridinio)-1-propanesulfonate and 3-(benzyl-dimethyl-ammonio)propanesulfonate; compounds comprising both a phosphoric acid group and a quaternary ammonium group, for example with hexadecyl phosphocholine, compounds comprising a quaternary ammonium group with an attached hydroxy group, for example lauryldimethylamine N-oxide, and phospholipids, which consist of a quaternary ammonium head coupled via a phosphate group and glycerol to two hydrophobic fatty acids.

Particular preferred surfactants are the commercially available surfactants available under the trademarks Dynol® and Zonyl®.

Preferred adhesion promoters are organofunctional silanes or hydrolysates thereof such as 3-glycidoxypropyltrialkoxysilane, 3-amino-propyl-triethoxysilane, 3-mercaptopropyltrimethoxysilane, 3-methacryloxypropyltrimethoxysilane, vinyltrimethoxysilane or octyltriethoxysilane.

Preferred crosslinking agents are melamine compounds, blocked isocyanates, functional silanes such as tetraethoxysilane, alkoxysilane hydrolysates, such as tetraethoxysilane, epoxysilanes, such as 3-glycidoxy-propyltrialkoxysilane.

Particularly preferred crosslinking agents are tetraalkyl orthosilicates. Preferred tetraalkyl orthosiliscates are selected from the group consisting of tetramethyl orthosilicate, tetraethyl orthosilicate, tetrapropyl orthosilicate, tetrabutyl orthosilicate, tetrapentyl orthosilicate, orthosilicate, an at least partially hydrolysed product of these orthosilicates, wherein tetraethyl orthosilicate (TEOS) is particularly preferred.

The amount of crosslinking agent is preferably from 0.01 to 15 wt%, more preferably from 0.1 to 10 wt%, most

preferably from 1 to 5 wt% all relative to the total weight of the liquid formulation.

Suitable binders are selected from the group consisting of polyvinyl alcohols, polyvinylpyrrolidones, polyvinyl chlorides, polyvinyl acetates, polyvinyl butyrates, polyacrylic esters, polyacrylamides, polymethacrylic esters, polymethacrylamides, polyacrylonitriles, styrene/acrylic ester, vinyl acetate/acrylic ester, ethylene/vinyl acetate copolymers, polybutadienes, polyisoprenes, polystyrenes, polyethers, polyesters, sulfonated polyesters, polycarbonates, polyurethanes, polyamides, polyimides, polysulfones, melamine-formaldehyde resins, epoxy resins, silicone resins, silane resins, celluloses or a mixture of at least two of these binders.

Other suitable binders are those which are obtained by adding crosslinkers, for example melamine compounds, capped isocyanates or functional silanes, for example 3-glycidoxypropyltrialkoxysilane, tetraethyl orthosilicate and tetraethyl orthosilicate hydrolyzate, to crosslinkable polymers, for example polyurethanes, polyacrylates or polyolefins, and subsequently crosslinking.

Highly preferred binders are watersoluble binders, such as sulfonated polyesters.

The liquid formulation preferably includes a high-boiling solvent, such as propylene glycol, ethylene glycol, diethylene glycol, dimethylsulphoxide (DMSO), methylacetamide, dimethylacetamide, dimethylformamide, N-methylpyrrolidone, N-cyclohexylpyrrolidone or a mixture of at least two of these solvents.

Addition of such high-boiling solvents to the liquid formulation in an amount from 0.1 to 10 wt%, preferably from 0.5 to 5 wt%, relative to the total weight of the liquid formulation may lead to a significant increase in conductivity.

Highly preferred high-boiling solvents are selected from the group consisting of N-hydroxyethyl-pyrrolidone, DMSO, ethylene glycol and diethylene glycol.

A preferred stability improving compound is gallic acid or a derivative thereof wherein preferred derivatives are gallic acid esters.

Particularly preferred gallic acid esters are esters of gallic acid and sugar which are often called tannin or gallotannins. Further preferred esters of gallic acid are alkyl esters, alkenyl esters, cycloalkyl esters, cycloalkenyl esters and aryl esters of gallic acid, preferably those having 1 to 15 C-atoms, preferably 1 to 6 C atoms in the alkyl group, the alkenyl group, the cycloalkyl group, the cycloalkenyl group or the aryl group of the ester.

Preferred derivatives of gallic acid are gallo-tannines, such as tannic acid, or alkylesters of gallic acid such as methyl gallate, ethyl gallate, propyl gallate or a mixture of at least two of these esters.

The amount of the stability improving compound is preferably from 0.01 to 10 wt%, more preferably 0.1 to 5 wt%, most preferably 0.5 to 2.5 wt%, in each case based on the total weight of the liquid formulation.

The pH of the liquid formulation is typically between 1.5 and 8.0.

The pH can be adjusted by adding appropriate acids or bases to the liquid formulation. Suitable acids are inorganic acids or organic acids. Examples of inorganic acids are sulfuric acid, hydrochloric acid, nitric acid, phosphoric acid, silicic acid or a combination thereof. Examples of organic acids are acetic acid, formic acid, benzoic acid, p-toluenesulfonic acid, PSS or a combination thereof. Suitable bases are inorganic bases or organic bases. Examples of inorganic bases are sodium hydroxide, potassium hydroxide, ammonium hydroxide, sodium carbonate or a combination thereof. Examples of organic bases are dimethylaminoethanol, imidazole, ammonia, alkylamines or a combination thereof.

The viscosity of the liquid formulation is preferably between 5 and 1000 mPa.s, measured with a rheometer at 20°C and a shear rate of 100 $s^{-1}$, more preferably between 15 and 500 mPa.s, most preferably between 20 and 100 mPa.s.

The adjustment of the viscosity can, for example, be accomplished by adding appropriate rheology modifiers to the liquid formulation.

Furthermore it is preferred that, if $V_{t0}$ is the viscosity of the liquid formulation at the point of time t = 0 and if $V_{t0+6\ month}$ is the viscosity of the same liquid formulation after it has been stored for 6 month at 25°C in a closed container, the change of the viscosity is not more than 20 %, preferably not more than 10 % and more preferably not more than 5 %, wherein the change of the viscosity ($\Delta V$) is calculated as follows:

$$\Delta V = 100\% \times (V_{to+\ 6\ month} - V_{to})/V_{to}$$

It is furthermore preferred that a conductive layer prepared with the liquid formulation is characterized by at least one of the following properties, preferably by all of these properties:

- a sheet resistance in a range from $1 \times 10^2$ to $1 \times 10^{10}$ Ω/sq, preferably in the range from $1 \times 10^3$ to $1 \times 10^9$ Ω/sq;
- a transmission of at least 98 %, preferably at least 98.5 %, more preferably at least 99 % and most preferably at least 99.5 %;
- a pencil hardness of at least 6H, preferably at least 7H, more preferably at least 8H and most preferably at least preferably at least 9H.

In this context it is particularly preferred that, if $SR_{t0}$, $T_{t0}$ and $PH_{t0}$ are the sheet resistance, the transmission and the pencil hardness of a conductive layer prepared by applying the liquid formulation at the point of time t = 0 onto a substrate in a wet film thickness of 12 mm followed by a removal of the solvent and if $SR_{t0+6}$ month, $T_{t0+6}$ month and $PH_{t0+6}$ month are the sheet resistance, the transmission and the pencil hardness of a conductive layer prepared by applying the same liquid formulation, after it has been stored for 6 month at 25°C in a closed container, onto a substrate in a wet film thickness of 12 mm followed by a removal of the solvent at least one of the following properties, preferably all of these properties, are fulfilled:

- the sheet resistance changes by not more than 20 %, preferably not more than 10 % and most preferably not more than 5 %, wherein the change of the sheet resistances (ΔSR) is calculated as follows:

$$\Delta SR = 100\% \times (SR_{to+6\ month} - SR_{to})/SR_{to}$$

- the transmission changes by not more than 20 %, preferably not more than 10 % and most preferably not more than 5 %, wherein the change of the transmission (ΔT) is calculated as follows:

$$\Delta T = 100\% \times (T_{to+6\ month} - T_{to})/T_{to}$$

- the pencil hardness changes by not more than 20 %, preferably not more than 10 % and most preferably not more than 5 %, wherein the change of the pencil hardness (ΔPH) is calculated as follows:

$$\Delta PH = 100\% \times (PH_{to+6\ month} - PH_{to})/PH_{to}$$

The solids content of the liquid formulation is preferably from 0.01 to 20 wt%, more preferably from 0.1 to 15 wt%, most preferably from 0.25 to 10 wt%, in each case based on the total weight of the formulation.

<u>A layered body</u>

A layered body according to the present invention comprises an electrically conductive layer provided on a substrate, the electrically conductive layer comprising:

(a) at least one oligo- or polythiophene obtained by copolymerization of at least one monomer according to Formula I and at least one monomer according to Formula II,

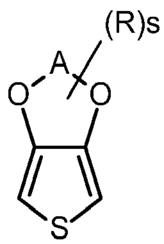

Formula I

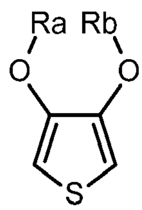

Formula II

wherein

A represents a substituted or unsubstituted $C_1$ to $C_5$ alkylene bridge;
R is selected from the group consisting of a linear or branched substituted or unsubstituted $C_1$-$C_{18}$-alkyl group, a substituted or unsubstituted $C_5$-$C_{12}$-cycloalkyl group, a substituted or unsubstituted $C_6$-$C_{14}$-aryl group, a substituted or unsubstituted $C_7$-$C_{18}$-aralkyl group, a substituted or unsubstituted $C_1$-$C_4$-hydroxyalkyl group and a hydroxyl group;
s represents an integer from 0 to 8;
Ra and Rb are independently selected from the group consisting of hydrogen, a substituted or unsubstituted alkyl group, a substituted or unsubstituted alkenyl group, a substituted or unsubstituted alkynyl group, a substituted or unsubstituted aralkyl group, a substituted or unsubstituted alkaryl group and a substituted or unsubstituted aryl or heteroaryl group;

(b) at least one polymeric polyanion, wherein at least 75 mol% of the monomeric units of the polymeric polyanion are functionalized with a functional group selected from the group consisting of a sulfonic acid or salt thereof, a phosphonic acid or salt thereof, a phosphate ester or salt thereof, a sulfate ester or salt thereof and a carboxylic acid or salt thereof,

characterized in that the weight ratio of the monomer according to Formula I to the monomer according to Formula II is from 75/25 to 25/75, preferably from 70/30 to 40/60, more preferably from 65/35 to 50/50.

Preferred substrates are plastics such as polycarbonate, polyethylene, polyethylene terephthalate (PET), polyamide, and polypropylene.

A surface activation such as a Corona treatment may be performed prior to applying the liquid formulation, for example in the case of PET and polyolefins to enhance adhesion to the substrate.

The substrate may also be a glass plate.

The electrically conductive layer is preferably characterized by at least one of the following properties, more preferably by all of these properties:

- a sheet resistance in a range from $1 \times 10^2$ to $1 \times 10^{10}$ Ω/sq, preferably in the range from $1 \times 10^3$ to $1 \times 10^9$ Ω/sq;
- a transmission of at least 98 %, preferably at least 98.5 %, more preferably at least 99 % and most preferably at least 99.5 %;
- a pencil hardness of at least 6H, preferably at least 7H, more preferably at least 8H and most preferably at least preferably at least 9H.

The layered bodies according to the present invention are suitable for use as electronic components, in particular as conductive or antistatic means, as transparent heating or as electrodes.

The layered bodies can be employed as electronic components, for example on films, packaging of electronic components, for finishing films of plastics and for coating screens. They can furthermore be used as transparent electrodes e.g. in displays, for example as a substitute for indium-tin oxide electrodes, or as electrical conductors in polymeric electronics. Further possible uses are sensors, batteries, solar cells, electrochromic windows (smart windows) and displays and corrosion protection.

In view of the UV-stability and scratch resistance of the coatings obtained with the liquid formulation according to the present invention these liquid formulations are particularly useful for the production of an antistatic coating or an electromagnetic radiation shield. They are furthermore particularly useful for the preparation of a hole-transport layer in an organic light emitting diode (OLED) or in an organic photovoltaic (OPV) element.

<u>Method of preparing a layered body</u>

The method of preparing a layered body comprises the steps of:

i) providing a substrate;
ii) applying a liquid formulation according to the present invention;
iii) at least partially removing a solvent from the liquid composition to obtain a layered body comprising an electrically conductive layer coated onto the substrate.

In step i) a substrate is first provided, wherein the nature of the substrate depends on the intended purpose for which the composition according to the present invention is employed. In step ii) the liquid composition according to the present invention is applied onto the substrate. Application of the liquid formulation may be carried out by known processes, e.g. by spin coating, impregnation, pouring, dripping on, spraying, misting, knife coating, brushing or printing, for example by ink-jet, screen, gravure, offset or tampon printing.

In step iii) a solvent is at least partially removed to obtain a layered body comprising an electrically conductive layer coated onto the substrate. The removal is preferably carried out by a drying at a temperature in a range of from 20°C to 200°C of the substrate coated with the composition.

## EXAMPLES

### Materials

All materials used in the following examples were readily available from standard sources such as ALDRICH CHEMICAL Co. (Belgium) and ACROS (Belgium) unless otherwise specified. The water used was deionized water.

**EDOT** is 3,4-ethylenedioxythiophene commercially available from Heraeus.

**DMOT** is 3,4-dimethoxythiophene commercially available from Fluorochem Ltd.

**PSS** is an aqueous solution of polystyrenesulfonic acid having a Mw of 300 kDa prepared according to a method disclosed in Houben-Weyl, Methoden der organischen Chemie, Vol. E 20, Makromolekulaire Stoffe, Teil 2 (1987), page 1141).

**Lewatit ® MonoPlus M600** is a basic, gelular anion exchange resin commercially available from Lanxess AG.

**Lewatit ® MonoPlus S 108 H** is an acidic, gelular anion exchange resin commercially available from Lanxess AG.

### Methods

Surface resistance measurement

The surface resistance SER was measured at room temperature using a two point probe method.

Viscosity measurement

The viscosity was measured with a glass capillary viscometer.

Gelation stability measurement

The gelation stability was evaluated by mixing equal amounts of an organic solvent and the conductive polymer dispersion and visually assessing the gelation behavior over time. The samples were stored at room temperature or at 30 °C. A quantitative measure for the gelation behavior was determined (1-5), where 1 corresponds to no viscosity increase observed and 5 to completely gelated.

Example 1: Synthesis of P($EDOT_{0.90}$:$DMOT_{0.10}$):PSS

An aqueous solution of PSS (297 g, 5.74 wt%) and deionized water (1288 mL) were mixed in a reaction vessel under a nitrogen flow. EDOT (6.17 g, 43.4 mmol) and DMOT (0.69 g, 4.8 mmol) were added. The reaction mixture was heated to 30 °C while stirring. Then, a solution of iron(III) sulfate (0.31 g, 0.77 mmol) in deionized water (6.4 mL) was added. Sodium persulfate (13.7 g, 57.8 mmol) was added and the reaction mixture stirred for 6 hours. An additional amount of sodium persulfate (2.3 g, 9.6 mmol) was added to the reaction mixture and stirred for another 16 hours. The reaction mixture was treated with ion exchanger (223.9 g Lewatit ® MonoPlus M600 + 419.4 g Lewatit ® MonoPlus S 108 H, filtered and washed 2× 120 mL water, repeated).

The resulting viscous mixture was split in two and treated with high shear homogenization to obtain two samples (Lab Gaulin, a: 1× 600 bar and b: 4× 600 bar). The dispersion was concentrated in vacuo.

This procedure yielded blue dispersions of PEDOT:PSS in water (a: 1.12 wt% and b: 1.24 wt%).

Example 2: Synthesis of P($EDOT_{0.80}$:$DMOT_{0.20}$):PSS

A polymerization was carried out in the same manner as in Example 1 except for using 5.49 g of EDOT and 1.37 of DMOT. The reaction mixture was treated with ion exchanger (223.5 g Lewatit ® MonoPlus M600 + 418.8 g Lewatit ® MonoPlus S 108 H, filtered and washed 2× 120 mL water, repeated).

This procedure yielded blue dispersions of PEDOT:PSS in water (a: 1.12 wt% and b: 1.24 wt%).

Example 3: Synthesis of P($EDOT_{0.65}$:$DMOT_{0.35}$):PSS

A polymerization was carried out in the same manner as in Example 1 except for using 298.66 of poly(4-vinylbenzenesulfonic acid), 4.46 g of EDOT and 2.4 of DMOT. The reaction mixture was treated with ion exchanger (223.1 g Lewatit ® MonoPlus M600 + 417.9 g Lewatit ® MonoPlus S 108 H, filtered and washed 2× 120 mL water, repeated).

This procedure yielded blue dispersions of PEDOT:PSS in water (a: 1.23 wt% and b: 1.12 wt%).

Example 4: Synthesis of P($EDOT_{0.50}$:$DMOT_{0.50}$):PSS

A polymerization was carried out in the same manner as in Example 3 except for using 3.43 g of EDOT and 3.43 of DMOT. The reaction mixture was treated with ion exchanger (222.6 g Lewatit ® MonoPlus M600 + 417.0 g Lewatit ® MonoPlus S 108 H, filtered and washed 2× 120 mL water, repeated).

This procedure yielded blue dispersions of PEDOT:PSS in water (a: 1.21 wt% and b: 1.33 wt%).

Comparative example 1: Polymerization of PEDOT:PSS

An aqueous solution of PSS (73.2 g, 5.85 wt%) and deionized water (323 mL) were mixed in a reaction vessel under a nitrogen flow. EDOT (1.71 g, 12.1 mmol) was added. The reaction mixture was heated to 30 °C while stirring. Then, a solution of iron(III) sulfate (0.077 g, 0.19 mmol) in deionized water (1.6 mL) was added. Sodium persulfate (3.45 g, 14.5 mmol) was added and the reaction mixture was stirred for 6 hours. An additional amount of sodium persulfate (0.57 g, 2.42 mmol) was added to the reaction mixture was stirred for another 16 hours. The reaction mixture is treated with ion exchanger (56.1 g Lewatit ® MonoPlus M600 + 105.1 g Lewatit ® MonoPlus S 108 H, filtered, repeated).

The resulting viscous mixture was treated with high shear homogenization (Lab Gaulin, 1× 600 bar). The dispersion is concentrated in vacuo.

This procedure yielded a blue dispersion of PEDOT:PSS in water (1.14 wt%).

Comparative example 2: Polymerization of PEDOT:PSS

An aqueous solution of PSS (347 g, 5.86 wt%) and deionized water (1525 mL) were mixed in a reaction vessel under nitrogen bubbling. EDOT (8.14 g, 57.3 mmol) was added. The reaction mixture was heated to 30 °C while stirring. Then, a solution of iron(III) sulfate (0.37 g, 0.93 mmol) in deionized water (20 mL) was added. Sodium persulfate (16.4 g, 68.8 mmol) was added and the reaction mixture was stirred for 6 hours. An additional amount of sodium persulfate (2.7 g, 11.3 mmol) was added to the reaction mixture was stirred for another 16 hours. 1L of the reaction mixture is treated with ion exchanger (150 g Lewatit ® MonoPlus M600 + 280 g Lewatit ® MonoPlus S 108 H, filtered, repeated).

The resulting viscous mixture was treated with high shear homogenization (Lab Gaulin, 4× 600 bar). The dispersion is concentrated in vacuo.

This procedure yielded a blue dispersion of PEDOT:PSS in water (1.22 wt%).

Example 5

The viscosity of the dispersions and SER of bar-coated films of these dispersions on PET, measured as described above, are shown in Table 2.

Table 2

| Dispersion | P(EDOT-co-DMOT):PPS | Homogenization | Viscosity (mPa.s) | SER (Ω/□) |
|---|---|---|---|---|
| DISP-01 | P($EDOT_{0.90}$:$DMOT_{0.10}$):PSS | 1× 600 bar | 69.3 | 2.83E+05 |
| DISP-02 | P($EDOT_{0.90}$:$DMOT_{0.10}$):PSS | 4× 600 bar | 40.7 | 1.08E+06 |
| DISP-03 | P($EDOT_{0.80}$:$DMOT_{0.20}$):PSS | 1× 600 bar | 26.5 | 1.77E+06 |
| DISP-04 | P($EDOT_{0.80}$:$DMOT_{0.20}$):PSS | 4× 600 bar | 14.2 | 4.02E+06 |
| DISP-05 | P($EDOT_{0.65}$:$DMOT_{0.35}$):PSS | 1× 600 bar | 13.8 | 6.52E+06 |
| DISP-06 | P($EDOT_{0.65}$:$DMOT_{0.35}$):PSS | 4× 600 bar | 9.3 | 6.61E+06 |
| DISP-07 | P($EDOT_{0.50}$:$DMOT_{0.50}$):PSS | 1× 600 bar | 8.4 | 5.10E+06 |
| DISP-08 | P($EDOT_{0.50}$:$DMOT_{0.50}$):PSS | 4× 600 bar | 7.3 | 4.76E+06 |
| DISP-C01 | PEDOT:PSS | 1× 600 bar | 51.8 | 1.62E+06 |
| DISP-C02 | PEDOT:PSS | 4× 600 bar | 41 | / |

It is clear from the results in Table 2 that the SER of films prepared with the dispersions with increasing amounts

of DMOT are comparable.

The viscosity of the dispersions decreases with increasing amount of DMOT and with enhanced homogenization.

Example 6

The gelation stability of the dispersions upon the addition of isopropanol was evaluated over time. The results are shown for storage at room temperature in Table 3 and for storage at 30 °C in Table 4.

Table 3

| | DAYS | | | | | | | |
|---|---|---|---|---|---|---|---|---|
| | 1 | 3 | 6 | 7 | 10 | 17 | 22 | 28 |
| **DISP-01** | 5 | 5 | 5 | / | 5 | 5 | 5 | 5 |
| **DISP-02** | 5 | 5 | 5 | / | 5 | 5 | 5 | 5 |
| **DISP-03** | 1 | 3 | 4 | / | 5 | 5 | 5 | 5 |
| **DISP-04** | 1 | 3 | 4 | / | 5 | 5 | 5 | 5 |
| **DISP-05** | 1 | 1 | 2 | / | 2 | 3 | 3 | 4 |
| **DISP-06** | 1 | 1 | 1 | / | 1 | 2 | 2 | 3 |
| **DISP-07** | 1 | 1 | 1 | / | 1 | 1 | 1 | 1 |
| **DISP-08** | 1 | 1 | 1 | / | 1 | 1 | 1 | 1 |
| **DISP-C02** | 2 | / | / | 5 | / | / | / | / |

Table 4

| | DAYS | | | | | | | |
|---|---|---|---|---|---|---|---|---|
| | 1 | 3 | 6 | 7 | 10 | 17 | 22 | 28 |
| **DISP-01** | 5 | 5 | 5 | / | 5 | 5 | 5 | 5 |
| **DISP-02** | 5 | 5 | 5 | / | 5 | 5 | 5 | 5 |
| **DISP-03** | 3 | 4 | 5 | / | 5 | 5 | 5 | 5 |
| **DISP-04** | 1 | 4 | 5 | / | 5 | 5 | 5 | 5 |
| **DISP-05** | 1 | 2 | 2 | / | 3 | 4 | 4 | 4 |
| **DISP-06** | 1 | 1 | 1 | / | 1 | 4 | 4 | 4 |
| **DISP-07** | 1 | 1 | 1 | / | 1 | 1 | 1 | 1 |
| **DISP-08** | 1 | 1 | 1 | / | 1 | 1 | 1 | 1 |
| **DISP-C02** | 4 | / | / | 5 | / | / | / | / |

It is clear from the results in Tables 3 and 4 that dispersions containing copolymers with increasing amounts of DMOT show an improved gelation stability for isopropanol addition.

Example 7

The gelation stability of the dispersions upon the addition of ethanol was evaluated over time. The results are shown for storage at room temperature in Table 5 and for storage at 30 °C in Table 6.

Table 5

| | DAYS | | | | | | | |
|---|---|---|---|---|---|---|---|---|
| | 1 | 3 | 6 | 7 | 10 | 17 | 22 | 28 |
| DISP-01 | 5 | 5 | 5 | / | 5 | 5 | 5 | 5 |
| DISP-02 | 5 | 5 | 5 | / | 5 | 5 | 5 | 5 |
| DISP-03 | 1 | 3 | 4 | / | 5 | 5 | 5 | 5 |
| DISP-04 | 1 | 2 | 4 | / | 5 | 5 | 5 | 5 |
| DISP-05 | 1 | 1 | 2 | / | 2 | 3 | 3 | 4 |
| DISP-06 | 1 | 1 | 1 | / | 1 | 1 | 1 | 1 |
| DISP-07 | 1 | 1 | 1 | / | 1 | 1 | 1 | 1 |
| DISP-08 | 1 | 1 | 1 | / | 1 | 1 | 1 | 1 |
| DISP-C02 | 2 | / | / | 4 | / | / | / | / |

Table 6

| | DAYS | | | | | | | |
|---|---|---|---|---|---|---|---|---|
| | 1 | 3 | 6 | 7 | 10 | 17 | 22 | 28 |
| DISP-01 | 5 | 5 | 5 | / | 5 | 5 | 5 | 5 |
| DISP-02 | 5 | 5 | 5 | / | 5 | 5 | 5 | 5 |
| DISP-03 | 2 | 4 | 4 | / | 5 | 5 | 5 | 5 |
| DISP-04 | 1 | 4 | 4 | / | 5 | 5 | 5 | 5 |
| DISP-05 | 1 | 1 | 2 | / | 3 | 4 | 4 | 4 |
| DISP-06 | 1 | 1 | 1 | / | 1 | 2 | 2 | 2 |
| DISP-07 | 1 | 1 | 1 | / | 1 | 1 | 1 | 1 |
| DISP-08 | 1 | 1 | 1 | / | 1 | 1 | 1 | 1 |
| DISP-C02 | 4 | / | / | 4 | / | / | / | / |

It is clear from the results in Tables 5 and 6 that dispersions containing copolymers with increasing amounts of DMOT show an improved gelation stability for ethanol addition.

## Claims

**1.** A conductive polymer dispersion including:

(a) at least one oligo- or polythiophene obtained by copolymerization of at least one monomer according to Formula I and at least one monomer according to Formula II,

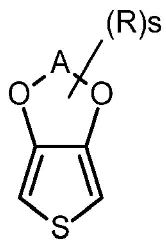

Formula I

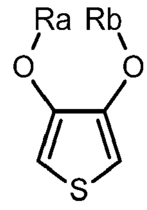

Formula II

wherein

A represents a substituted or unsubstituted $C_1$ to $C_5$ alkylene bridge;
R is selected from the group consisting of a linear or branched substituted or unsubstituted $C_1$-$C_{18}$-alkyl group, a substituted or unsubstituted $C_5$-$C_{12}$-cycloalkyl group, a substituted or unsubstituted $C_6$-$C_{14}$-aryl group, a substituted or unsubstituted $C_7$-$C_{18}$-aralkyl group and a hydroxyl group;
s represents an integer from 0 to 8;
Ra and Rb are independently from each other selected from the group consisting of hydrogen, a substituted or unsubstituted alkyl group, a substituted or unsubstituted alkenyl group, a substituted or unsubstituted alkynyl group, a substituted or unsubstituted aralkyl group, a substituted or unsubstituted alkaryl group and a substituted or unsubstituted aryl or heteroaryl group;

(b) a polymeric polyanion wherein at least 75 mol% of the monomeric units of the polymeric polyanion comprise a functional group selected from the group consisting of a sulfonic acid or salt thereof, a phosphonic acid or salt thereof, a phosphate ester or salt thereof, a sulfate ester or salt thereof and a carboxylic acid or salt thereof,

**characterized in that** a weight ratio of the monomer according to Formula I to the monomer according to Formula II is from 25/75 to 75/25.

2. The conductive polymer dispersion according to claim 1 wherein the weight ratio of the monomer according to Formula I to the monomer according to Formula II is from 50/50 to 65/35.

3. The conductive polymer dispersion according to claims 1 or 2 wherein the monomer according to Formula I is 3,4-ethylenedioxythiophene.

4. The conductive polymer dispersion according to any of the preceding claims wherein the monomer according to Formula II is 3,4-dimethoxythiophene.

5. The conductive polymer dispersion according to any of the preceding claims wherein the polymeric polyanion is poly(4-styrenesulfonic acid) or a salt thereof.

6. The conductive polymer dispersion according to any of the preceding claims wherein a weight average molecular weight (Mw) of the polymeric polyanion is from 50 000 to 500 000 Da.

7. The conductive polymer dispersion according to any of the preceding claims wherein the oligo- or polythiophene and the polyanion are present as polythiophene/polyanion particles having a median particle size ($d_{50}$) from 5 to 100 nm, measured by laser diffraction.

8. The conductive polymer dispersion according to claim 7 wherein the amount of the oligo- or polythiophene/polyanion particles is from 1.1 to 1.3 wt% relative to the total weight of the dispersion and wherein the viscosity of the dispersion is from 5 to 100 mPa.s measured at 20°C at a shear rate of 100 $s^{-1}$.

9. A liquid formulation including the conductive polymer dispersion according to any of the preceding claims.

10. The liquid formulation according to claim 9 comprising between 2 and 50 wt% relative to the total weight of the formulation of at least one organic solvent.

**11.** The liquid formulation according to claim 10 wherein the organic solvent is selected from the group consisting of methanol, ethanol, n-propanol, isopropanol, n-butanol or a combination thereof.

**12.** The liquid formulation according to any of the claims 9 to 11 further comprising an acid, a base, a high-boiling solvent, an adhesion promoter, a crosslinking agent, a surfactant, a binder or a combination thereof.

**13.** The use of a liquid formulation according to any of the claims 9 to 12 for the preparation of an antistatic coating or an electromagnetic radiation shield or for the preparation of a hole-transport layer in an organic light emitting diode (OLED) or in an organic photovoltaic (OPV) element.

**14.** A process for the preparation of a layered body comprising the steps of:

(i) providing a substrate;
(ii) applying a liquid formulation according to any of the claims 9 to 12 onto the substrate;
(iii) at least partial removing a solvent from the liquid formulation to obtain a layered body comprising an electrically conductive layer onto the substrate.

**15.** A layered body comprising an electrically conductive layer provided on a substrate, the electrically conductive layer comprising:

(a) at least one oligo- or polythiophene obtained by copolymerization of at least one monomer according to Formula I and at least one monomer according to Formula II,

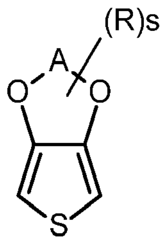

Formula I

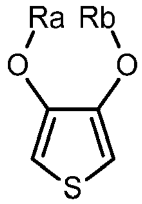

Formula II

wherein

A represents a substituted or unsubstituted $C_1$ to $C_5$ alkylene bridge;
R is selected from the group consisting of a linear or branched substituted or unsubstituted $C_1$-$C_{18}$-alkyl group, a substituted or unsubstituted $C_5$-$C_{12}$-cycloalkyl group, a substituted or unsubstituted $C_6$-$C_{14}$-aryl group, a substituted or unsubstituted $C_7$-$C_{18}$-aralkyl group and a hydroxyl group;
s represents an integer from 0 to 8;
Ra and Rb are independently from each other selected from the group consisting of hydrogen, a substituted or unsubstituted alkyl group, a substituted or unsubstituted alkenyl group, a substituted or unsubstituted alkynyl group, a substituted or unsubstituted aralkyl group, a substituted or unsubstituted alkaryl group and a substituted or unsubstituted aryl or heteroaryl group;

(b) a polymeric polyanion wherein at least 75 mol% of the monomeric units of the polymeric polyanion comprise a functional group selected from the group consisting of a sulfonic acid or salt thereof, a phosphonic acid or salt thereof, a phosphate ester or salt thereof, a sulfate ester or salt thereof and a carboxylic acid or salt thereof,

**characterized in that** a weight ratio of the monomer according to Formula I to the monomer according to Formula II is from 25/75 to 75/25.

Europäisches Patentamt
European Patent Office
Office européen des brevets

# EUROPEAN SEARCH REPORT

Application Number
EP 22 17 4528

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>Y | US 2013/023621 A1 (SESHADRI VENKATARAMANAN [US] ET AL) 24 January 2013 (2013-01-24)<br>* abstract;<br>paragraphs [0001], [0023], [0081], [0082], [0084], [0086], [0090]; claims 22, 24, 35, 37, 39, 40, 42; examples *<br>----- | 1-15<br><br>4,6,8,10,11 | INV.<br>C08G61/12<br>C09D165/00<br>C08L65/00<br>H01L51/00 |
| Y,D | WO 2021/172199 A1 (PANASONIC IP MAN CO LTD [JP]) 2 September 2021 (2021-09-02)<br>* paragraph [0001]; claims; examples; table 1 *<br>----- | 4,6 | |
| Y | WO 02/080627 A2 (AGFA GEVAERT [BE]) 10 October 2002 (2002-10-10)<br>* page 2, lines 21 to 30; examples; table 1 *<br>----- | 8,10,11 | |

TECHNICAL FIELDS SEARCHED (IPC)

C08G
C09D
C08L

The present search report has been drawn up for all claims

1

| Place of search | Date of completion of the search | Examiner |
|---|---|---|
| Munich | 25 November 2022 | Kahl, Philipp |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 22 17 4528

This annex lists the patent family members relating to the patent documents cited in the above-mentioned European search report. The members are as contained in the European Patent Office EDP file on
The European Patent Office is in no way liable for these particulars which are merely given for the purpose of information.

25-11-2022

| Patent document cited in search report | Publication date | Patent family member(s) | Publication date |
|---|---|---|---|
| US 2013023621 A1 | 24-01-2013 | EP 2513187 A2 | 24-10-2012 |
| | | JP 2013515094 A | 02-05-2013 |
| | | KR 20120106795 A | 26-09-2012 |
| | | KR 20180050769 A | 15-05-2018 |
| | | US 2013023621 A1 | 24-01-2013 |
| | | WO 2011075644 A2 | 23-06-2011 |
| WO 2021172199 A1 | 02-09-2021 | CN 115104165 A | 23-09-2022 |
| | | JP WO2021172199 A1 | 02-09-2021 |
| | | US 2022367121 A1 | 17-11-2022 |
| | | WO 2021172199 A1 | 02-09-2021 |
| WO 02080627 A2 | 10-10-2002 | AU 2002308173 A1 | 15-10-2002 |
| | | AU 2002315256 A1 | 15-10-2002 |
| | | CN 1509587 A | 30-06-2004 |
| | | CN 1527854 A | 08-09-2004 |
| | | DE 60210429 T2 | 23-11-2006 |
| | | EP 1374644 A2 | 02-01-2004 |
| | | EP 1383819 A2 | 28-01-2004 |
| | | JP 3855167 B2 | 06-12-2006 |
| | | JP 4500492 B2 | 14-07-2010 |
| | | JP 2004532307 A | 21-10-2004 |
| | | JP 2005501373 A | 13-01-2005 |
| | | KR 20030097813 A | 31-12-2003 |
| | | KR 20040011487 A | 05-02-2004 |
| | | TW I235171 B | 01-07-2005 |
| | | TW I283140 B | 21-06-2007 |
| | | WO 02079316 A2 | 10-10-2002 |
| | | WO 02080627 A2 | 10-10-2002 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2021172199 A
- US 9613757 B
- US 9036333 B
- JP 2012255049 B
- EP 11453877 A
- EP 1384739 A, Heraeus


### Non-patent literature cited in the description


- Handbook of Conducting Polymers. Marcel Dekker, 1986, vol. 1, 46-57
- **HOUBEN-WEYL.** Methoden der organischen Chemie. *Makromolekulaire Stoffe,* 1987, vol. E 20 (2), 1141